(19) Europäisches Patentamt

European Patent Office

Office européen des brevets

(11) **EP 4 184 401 A1**

(12) **EUROPEAN PATENT APPLICATION**

(43) Date of publication:
**24.05.2023 Bulletin 2023/21**

(21) Application number: **22207690.3**

(22) Date of filing: **16.11.2022**

(51) International Patent Classification (IPC):
**G06Q 10/0631** (2023.01)    **G06Q 50/06** (2012.01)

(52) Cooperative Patent Classification (CPC):
**G06Q 10/0631; G06Q 50/06**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.11.2021 US 202117530523**

(71) Applicant: **Air Products and Chemicals, Inc.**
**Allentown, PA 18106-5500 (US)**

(72) Inventors:
 • **Latshaw, Catherine Catino**
  **Fogelsville, 18051 (US)**

 • **Guter, Eric J**
  **Corona del Mar, 92625 (US)**
 • **Chen, Ye**
  **Allentown, 18104 (US)**
 • **Isom, Joshua D.**
  **Allentown, 18103 (US)**
 • **Stamps, Andrew T.**
  **Breinigsville, 18031 (US)**
 • **Urich, Matthew D**
  **Emmaus, 18049 (US)**
 • **Goheen, Christopher H**
  **Waynesboro, 17268 (US)**

(74) Representative: **Beck Greener LLP**
**Fulwood House**
**12 Fulwood Place**
**London WC1V 6HR (GB)**

(54) **A CONTROL SYSTEM FOR A FUEL SUPPLY NETWORK**

(57)    A method of controlling a fuel supply network , the method comprising: defining a directed acyclic graph comprising a set of fuel pathways; defining a set of reportable fuel pathways as a set of linear equations, the set of reportable fuel pathways comprising a subset of the set of fuel pathways; solving the set of linear equations to determine designated pathway quantities for the set of reportable fuel pathways; determining one or more throughput setpoint values for one or more edges in the directed acyclic graph based on the designated pathway quantities for one or more reportable fuel pathways associated with said one or more edges; controlling one or more control elements of the processes associated with the one or more edges based on the determined throughput setpoint values for the respective one or more edges.

*Fig. 1*

**Description**

The present invention relates to a method and system for control of a fuel supply network. More particularly, the present invention relates to the control of fuel supply networks for the production, processing, and distribution of transportation fuels using a pathway-designating methodology.

Fuel supply networks comprise one or more processes defining the production, transformation, transporting and distribution of gaseous and liquid fuels for end-applications.

In general, the inputs to fuel supply networks are feedstock elements. Examples of such elements are crude natural gas, crude oil, canola oil, electricity, solar energy, wind energy, landfill gas, biomass, used motor oil, waste plastic, soybean oil, food scraps, and used cooking oil. The primary outputs of fuel supply networks are gaseous and liquid fuels. In non-limiting embodiments, these fuels may comprise transportation fuels such as biodiesel, gasoline, compressed natural gas, diesel, ethanol, gaseous hydrogen, liquefied natural gas, liquid hydrogen, propane, and renewable diesel.

Fuel supply networks are significant because they supply fuels vital for the functioning of economies around the world. However, fuel supply networks are increasingly scrutinized because the production, processing, distribution, and end uses of transportation fuels are often associated with the environmental pollutants.

In recent years, incentives have been introduced to improve the efficiency of, and reduce the environmental emissions of, fuel supply networks. For example, in California, the Low Carbon Fuel Standard provides benefits to fuel suppliers who certify fuel pathways and report on the quantities of fuels delivered via certified fuel pathways. A pathway comprises a defined sequence of processes leading from feedstocks to the end use of a transportation fuel.

Fuel supply networks typically include control systems which are used to regulate the throughput of feedstocks, intermediates, and fuels through each process. A control system may include setpoints for control elements (such as valves, blowers, compressors, or pumps) which regulate throughput in each process.

The throughput of feedstocks, intermediates, and fuels within each process of a fuel supply network materially affect the reportable pathway quantities. Further, reportable pathway quantities materially affect the operations of the operator of a fuel supply network. Finally, the development of a pathway-designating control system is complicated by the fact that the number of pathways in a fuel supply network may grow exponentially with the number of processes in the network.

Therefore, there exists a need in the art to provide more effective methods and systems to address these issues.

The following introduces a selection of concepts in a simplified form in order to provide a foundational understanding of some aspects of the present disclosure. The following is not an extensive overview of the disclosure and is not intended to identify key or critical elements of the disclosure or to delineate the scope of the disclosure. The following merely summarizes some of the concepts of the disclosure as a prelude to the more detailed description provided thereafter.

According to a first aspect, there is provided a method of controlling a fuel supply network comprising one or more feedstock sources, one or more processes and one or more end-use points, the method comprising: defining, using a processor, a directed acyclic graph representative of the fuel supply network, said directed acyclic graph comprising a set of fuel pathways, each fuel pathway extending between one or more source nodes each representative of a feedstock source of the fuel supply network to one or more sink nodes each representative of an end-use point of the fuel supply network and comprising one or more edges representative of one or more processes of the fuel supply network, wherein one or more edges are associated with a throughput determined by one or more control elements of the fuel supply network operable to control the process of the fuel supply network associated with the respective edge; defining, using a processor, a set of reportable fuel pathways as a system of linear equations, the set of reportable fuel pathways comprising a subset of the set of fuel pathways; calculating, using a processor, designated pathway quantities for the set of reportable fuel pathways such that the designated pathway quantities satisfy the system of linear equations; determining, using a processor, one or more throughput setpoint values for one or more edges in the directed acyclic graph based on the designated pathway quantities for one or more reportable fuel pathways associated with said one or more edges; controlling, using one or more controllers, one or more control elements of the processes associated with the one or more edges based on the determined throughput setpoint values for the respective one or more edges.

In embodiments, the step of determining average fuel pathway throughputs comprises determining the average throughput of one or more edges forming part of the respective fuel pathway within the predetermined time period.

In embodiments, the average throughput of one or more edges is determined by the setpoint values for said edge.

In embodiments, the average edge throughputs are calculated based on historical throughput for the respective edge and future edge throughput setpoint values for one or more epochs, each epoch being defined by a start time and a duration and falling within the predetermined time period.

In embodiments, wherein the step of defining a set of reportable pathways as a system of linear equations further comprises comprises expressing a vector of the average edge throughput over the predetermined time period as equal to a vector of the average pathway throughput over the period of time multiplied by a pathway matrix, wherein the elements of the pathway matrix may only take values of zero and one, and wherein an element of the matrix is equal to one if an edge is a member of a pathway and a zero if an edge is not a member of a pathway.

In embodiments, wherein the system of linear equations comprises a vector of the average edge throughputs over the period of time is equal to a vector of the average fuel pathway throughputs over the period of time multiplied by a matrix, the matrix consisting of only zeros and positive constants, and an element of the matrix equal to a positive constant if an edge is a member of a pathway and equal to zero if an edge is not a member of a pathway.

In embodiments, the rank of the pathway matrix is less than the number of reportable fuel pathways.

In embodiments, the method further comprises, prior to the step of defining a set of reportable pathways as a system of linear equations: determining a set of reportable fuel pathways from said set of fuel pathways.

In embodiments, wherein determining a set of reportable fuel pathways comprises: defining each edge as a member of a number of reportable fuel pathways for which a lower bound is the minimum of the number of pathways in the set of all fuel pathways which include the edge and a certain integer N.

In embodiments, N is 2, 3, or 4.

In embodiments, the set of reportable fuel pathways is determined based on a pairwise pathway similarity metric.

In embodiments, the pairwise path similarity metric is a function of the number of edges that are common to each reportable fuel pathway.

According to a second aspect of the present invention, there is provided a system for controlling a fuel supply network comprising one or more feedstock sources, one or more processes and one or more end-use points, the system comprising: at least one hardware processor operable to perform the steps of: defining, using a processor, a directed acyclic graph representative of the fuel supply network, said directed acyclic graph comprising a set of fuel pathways, each fuel pathway extending between one or more source nodes each representative of a feedstock source of the fuel supply network to one or more sink nodes each representative of an end-use point of the fuel supply network and comprising one or more edges representative of one or more processes of the fuel supply network, wherein one or more edges are associated with a throughput determined by one or more control elements of the fuel supply network operable to control the process of the fuel supply network associated with the respective edge; defining, using a processor, a set of reportable fuel pathways as a system of linear equations, the set of reportable fuel pathways comprising a subset of the set of fuel pathways; calculating, using a processor, designated pathway quantities for the set of reportable fuel pathways such that the designated pathway quantities satisfy the system of linear equations; determining, using a processor, one or more throughput setpoint values for one or more edges in the directed acyclic graph based on the designated pathway quantities for one or more reportable fuel pathways associated with said one or more edges; controlling, using one or more controllers, one or more control elements of the processes associated with the one or more edges based on the determined throughput setpoint values for the respective one or more edges.

In embodiments, the system further comprises a master controller, the master controller comprising one or more controllers operable to control the one or more control elements of the respective processes associated with the one or more edges.

In embodiments, the master controller further comprises a sensor module operable to receive and process sensor data from one or more sensors associated with the respective processes associated with the one or more edges.

In embodiments, one or more processes are selected from the group of: fuel production, transformation, transportation, distribution, or end-use processes.

According to a third aspect of the present invention, there is provided a computer readable storage medium storing a program of instructions executable by a machine to perform a method of controlling a fuel supply network comprising one or more feedstock sources, one or more processes and one or more end-use points, the method comprising: defining, using a processor, a directed acyclic graph representative of the fuel supply network, said directed acyclic graph comprising a set of fuel pathways, each fuel pathway extending between one or more source nodes each representative of a feedstock source of the fuel supply network to one or more sink nodes each representative of an end-use point of the fuel supply network and comprising one or more edges representative of one or more processes of the fuel supply network, wherein one or more edges are associated with a throughput determined by one or more control elements of the fuel supply network operable to control the process of the fuel supply network associated with the respective edge; defining, using a processor, a set of reportable fuel pathways as a system of linear equations, the set of reportable fuel pathways comprising a subset of the set of fuel pathways; calculating, using a processor, designated pathway quantities for the set of reportable fuel pathways such that the designated pathway quantities satisfy the system of linear equations; determining, using a processor, one or more throughput setpoint values for one or more edges in the directed acyclic graph based on the designated pathway quantities for one or more reportable fuel pathways associated with said one or more edges; controlling, using one or more controllers, one or more control elements of the processes associated with the one or more edges based on the determined throughput setpoint values for the respective one or more edges.

In embodiments, there is provided a system for controlling a fuel supply network comprising one or more feedstock sources, one or more processes and one or more end-use points, the system comprising: at least one hardware processor operable to perform the steps of: defining, using a processor, a directed acyclic graph representative of the fuel supply network, said directed acyclic graph comprising a set of fuel pathways, each fuel pathway extending between one or more source nodes each representative of a feedstock source of the fuel supply network to one or more sink nodes each representative of an end-use point of the fuel supply network and comprising one or more edges representative of one or more processes of the fuel supply network, wherein one or more edges are associated with a throughput determined by one or more control elements of the fuel supply network operable to control the process of the fuel supply network associated with the respective edge; defining, using a processor, a set of reportable fuel pathways as a system of linear equations, the set of reportable fuel pathways comprising a subset of the set of fuel pathways; calculating, using a processor, designated pathway quantities for the set of reportable fuel pathways such that the designated pathway quantities satisfy the system of linear equations; determining, using a processor, one or more throughput setpoint values for one or more edges in the directed acyclic graph based on the designated pathway quantities for one or more reportable fuel pathways associated with said one or more edges; controlling, using one or more controllers, one or more control elements of the processes associated with the one or more edges based on the determined throughput setpoint values for the respective one or more edges.

Embodiments of the present invention will now be described by example only and with reference to the figures in which:

FIGURE 1 is a schematic diagram of a generalised fuel supply network.

FIGURE 2 is a schematic diagram of a fuel supply network according to embodiments of the invention.

FIGURE 3a is a graphical representation of an edge, which is used is used in the invention to model a process in a fuel supply network.

FIGURE 3b is a graphical representation of a sequence of edges, which is used in the invention to model a pathway in a fuel supply network.

FIGURE 3c is a graphical representation of a source node.

FIGURE 3d is a graphical representation of a sink node.

FIGURE 3e is a graphical representation of a mixing node.

FIGURE 3f is a graphical representation of a splitter node.

FIGURE 4 is an example of a fuel supply network represented as a directed acyclic graph.

FIGURE 5 is another example of a fuel supply network represented as a directed acyclic graph.

FIGURE 6 is a flow diagram of a method according to an embodiment.

Embodiments of the present disclosure and their advantages are best understood by referring to the detailed description that follows. It should be appreciated that like reference numbers are used to identify like elements illustrated in one or more of the figures, wherein showings therein are for purposes of illustrating embodiments of the present disclosure and not for purposes of limiting the same.

Various examples and embodiments of the present disclosure will now be described. The following description provides specific details for a thorough understanding and enabling description of these examples. One of ordinary skill in the relevant art will understand, however, that one or more embodiments described herein may be practiced without many of these details. Likewise, one skilled in the relevant art will also understand that one or more embodiments of the present disclosure can include other features and/or functions not described in detail herein. Additionally, some well-known structures or functions may not be shown or described in detail below, so as to avoid unnecessarily obscuring the relevant description.

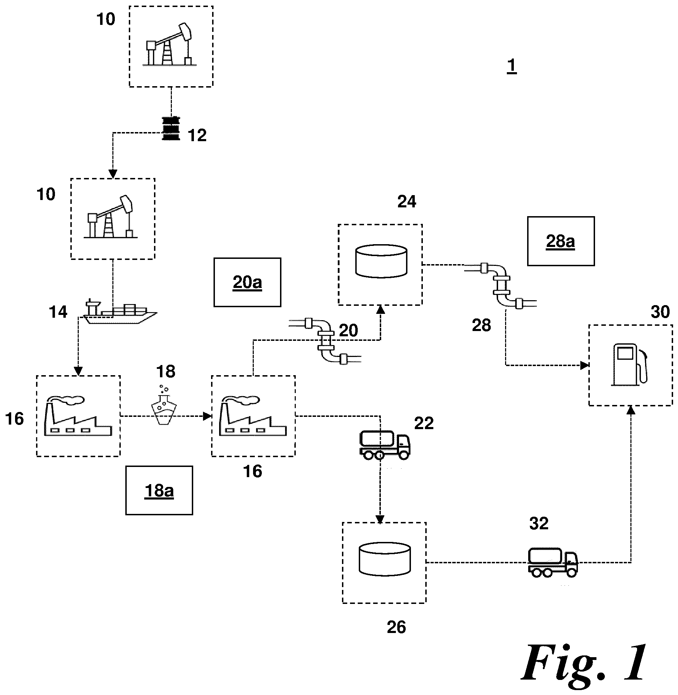

Figure 1 shows a general schematic diagram of an exemplary simple fuel supply network 1 for illustration purposes. The schematic diagram is represented such that nodes (shown in broken-line boxes) represent start point or end point locations connected by pathways (edges) which represent processes.

In Figure 1, an oil well 10 performs an extraction process 12 to extract crude oil. The crude oil is then shipped in a transportation process 14 to a refinery 16. A cracking process 18 is carried out in the refinery 16 to produce a suitable fuel.

The fuel is then transported by one of two transport processes 20, 22 which involve transportation by pipeline 20 or by road tanker 22 to respective storage terminals 24, 26. An onward transportation process 28 from the storage terminal 24 is carried out by pipeline to a fuel station 30. Similarly, an onward transportation process 32 is carried out by road tanker to transport fuel from storage terminal 26 to the fuel station 30 for end use.

The above example of Figure 1 is for illustrative purposes only. Compared to real-world fuel supply networks the example of Figure 1 is simplistic and has only two fuel pathways. Real-world fuel supply networks may comprise significantly more processes and the number of fuel pathways may grow exponentially with the number of processes.

Nevertheless, Figure 1 illustrates that each fuel pathway comprises a defined sequence of processes leading from feedstocks to the end-user location of a fuel station 30.

In order to regulate each of the processes within the fuel pathways, the network 1 includes control systems to regulate the throughput of feedstocks, intermediates, and fuels through each process. For example, for process 18 a controller 18a may be provided which is operable to control elements (such as valves, blowers, compressors, or pumps (not shown for clarity)) which regulate throughput in the process 18.

Additionally, pipeline controllers 20a, 28a may be provided for controlling the supply of produced fuel to the required destination. This may involve control of valves and pumps (not shown for clarity) as required to achieve the desired throughput of fuel to a designated resource.


*FUEL SUPPLY NETWORK CONTROL SYSTEMS*


In embodiments, the present invention provides a method of, and system for, controlling processes within a fuel supply network.

In embodiments, the present invention provides a control system utilising a pathway-designating approach to identify and define specific preferred pathways within a fuel supply network and to enable selective control of processes within the fuel supply network to achieve predetermined goals when operating the fuel supply network using these preferred pathways.

In embodiments, a pathway-designating control system for a fuel supply network utilises a controller which represents the fuel supply network as a directed acyclic graph in order to determine operational parameters of the fuel supply network as will be discussed below.

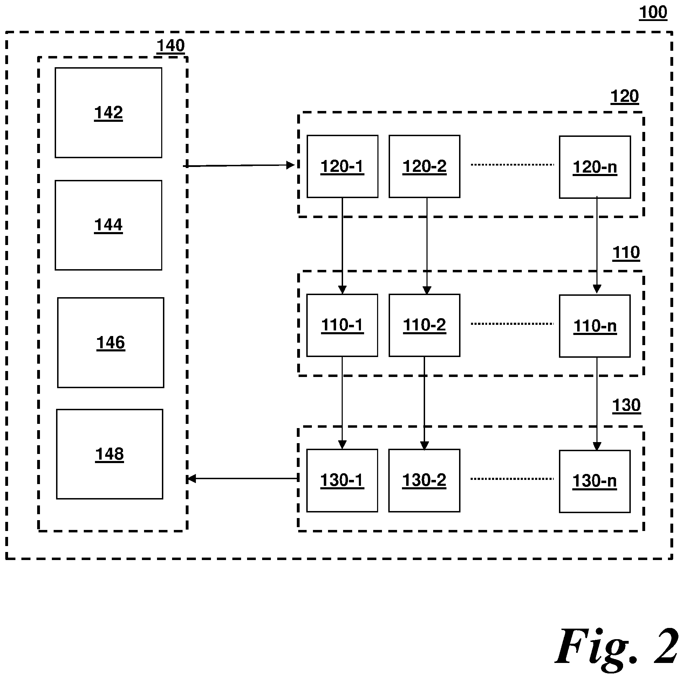

Figure 2 shows a schematic diagram of a fuel supply network control system 100 according to an embodiment.

The fuel supply network control system 100 comprises a plurality of processes 110-1, 110-2 ... 110-n within the fuel supply network. These may include, but are not limited to, the processes discussed and described with reference to Figure 1.

Fuel supply networks comprise a multiplicity of process each of which may have control systems for regulating the throughput of materials through each of the constituent processes. As noted above, at any given time, there is a throughput of materials through each process in a fuel supply network.

The fuel supply network control system 100 further comprises a control block 120 comprising a plurality of control elements 120-1, 120-2 ... 120-n associated with at least some of the processes 110. The throughput (or, in embodiments, flow) of materials (e.g. feedstocks, intermediates, and fuels) through and within each process is typically regulated by these control elements/control systems 120.

Such control systems are known in the art and typically maintain a control setpoint (e.g. a throughput or flow setpoint) and are associated with one or more sensors (such as, in non-limiting examples, flow rate meters, pressure sensors, temperature sensors etc.) and actuators (such as, in non-limiting examples, pumps, valves, compressors, or blowers) to regulate the throughput of materials through the process. These systems may comprise any suitable controller, for example, proportional-integral-derivative (PID) controllers.

Each process will, in practice, have a maximum and minimum operational capacity. In addition, in a dynamic operation a maximum rate of change will apply. These constraints are typically set by mechanical, electronic, material or other physical constraints within the equipment.

The difference between the maximum and minimum operating points defines the range of operation. Process constraints place constraints on the maximum and minimum capacity for each process, together with constraints on the rate of change of production capacity (i.e. ramp rates) in response to controller set point changes. Physical equipment limitations, quality and/or safety parameters may also apply.

The above limitations may be determined by the control block 120 and the process(es) controlled by a throughput setpoint value either determined locally or provided by the master controller 140 (described below).

The regulated throughput of materials in each process can affect the reportable pathway quantities for that process. For example, if the throughput through a particular process is zero for a determined period of time, then the designated pathway quantities for all pathways which include the process must also be equal to zero for that time period.

Alternatively, if the average throughput through a particular process has a defined non-zero value for a period of time, then the maximum designated pathway quantity for any pathway which includes the process is equal to the average throughput for the particular process. If the material being processed is a fluid, then the average throughput may correspond to the average flow of the fluid.

The throughput within one or more processes within one or more pathways may vary with time. In such a situation, the control system may be operable to regulate throughput independently for each time period and the reportable pathway quantities may be calculated by integrating the individual flows across the pathways over the entire reporting period.

The fuel supply network control system 100 may, in embodiments, further comprise a sensor block 130 comprising one or more sensors 130-1, 130-2 ... 130-n. These sensors 130 enable reporting of process parameters, for example the reporting of the Carbon intensity output from a given process.

The fuel supply network control system 100 further comprises a master controller 140. The master controller 140 comprises at least one hardware processor 142. The master controller 140 further comprises a pathway-designating module 144. In embodiments, the master controller 140 may further comprise a control module 146 operable to provide control signals (e.g. control setpoints) to the control block 120 to control one or more control elements 120-1, 120-2 ... 120-n of the process block 110.

Finally, the master controller 140 may comprise a sensor module 148 operable to receive and process sensor data from the sensor block 130.

*DIRECTED ACYCLIC GRAPH MODELLING OF A FUEL SUPPLY NETWORK*

The operation of the pathway designating module 144 will now be described. The pathway designating module 144 is operable to express the fuel supply network 100 as a directed acyclic graph to determine improved pathway designations for the fuel supply network as described below.

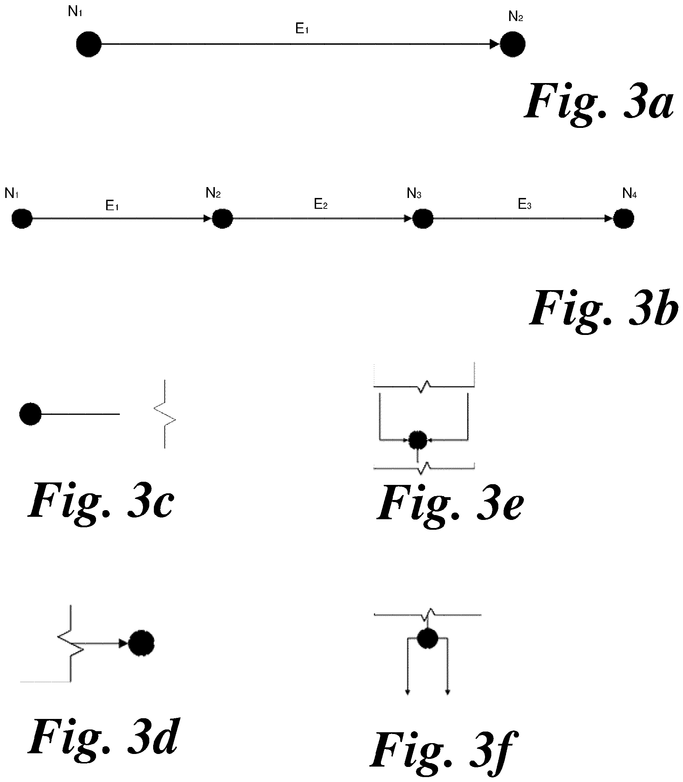

A directed acyclic graph comprises one or more nodes and one or more edges. Edges connect nodes and are directed from one node to another such that a closed loop cannot be defined. Figure 3a shows a graphical representation of two nodes $N_1$, $N_2$ connected by an edge $E_1$ having a direction from node $N_1$ to node $N_2$ as specified by the arrow. In embodiments, edges define processes 110 and associated nodes define start and end points for the edge therebetween. Thus, process defined by edge $E_1$ has start point $N_1$ and end point $N_2$.

The fuel supply network 100 comprises multiple disparate processes which are required to produce the fuel product and provide that fuel product to the required location for sale and/or consumption. In embodiments, each edge in a directed acyclic graph may correspond to a specific production, processing, transformation, transportation, distribution, or end-use process in the lifecycle of a fuel.

Concomitantly, the nodes associated with each process 110 are thus the start and end points of the respective process to which those nodes are associated. In other words, the aspect defined by each node depends upon the process defined by its associated edge.

In non-limiting examples, start and end nodes for a production process may be particular start and end products (e.g. in a cracking process, crude oil may be a start point and specific distilled fuel products may be end point) or may be locations (e.g. in a transportation process the start and end nodes may be the start and end locations of the transport process).

In embodiments, processes may be modelled with a software package. An example of a known software package is GREET® developed by Argonne National Laboratories.

Processes 110 may be categorised in numerous ways. In embodiments, processes may comprise stationary processes or transportation processes.

A stationary process may comprise a step of fuel production. For example, refining, processing, and purification of a fuel would comprise stationary processes because the process involves the transformation of a material in a substantially fixed location such as a refinery.

In non-limiting embodiments, examples of stationary processes may comprise one or more of the following: 1) heavy butane refining with pre-defined crude oil mixes; 2) high octane fuel (E25) production via blending; 3) high octane gasoline transportation; 4) high purity silicon production; 5) high-density polyethylene fabrication; 6) high-FFA oil transesterification to biodiesel; and 7) high-impact polystyrene production.

Transportation processes are utilised to describe how a material is transported from one location to another. Any suitable transportation process may be implemented in the modelling. Non-limiting examples include transportation of materials by one or more of: 1) pipeline transport; 2) road transport; 3) rail transport; 4) shipping tanker transport; 5) air transport.

At any given time, there is a throughput of materials through each process 110 in the fuel supply network 100. The throughput (or, in embodiments, flow if the materials are fluids) of materials (e.g. feedstocks, intermediates, and fuels) through and within each process is typically regulated by one or more control systems. Such control systems typically maintain a control setpoint (for example, in non-limiting embodiments, a flow rate setpoint) and are associated with one or more sensors (for example, in non-limiting embodiments where the material is a fluid, flow rate meters) and actuators (such as pumps, valves, compressors, or blowers) to regulate the throughput of materials through the process.

Within each process, work is done and each process requires energy to complete. In addition, some processes generate emissions and/or pollutants. Therefore, in general, each process in a fuel supply network will be associated with a particular production of Carbon dioxide depending upon the energy and/or emission properties of that process. It is thus defined that each process has a particular "Carbon intensity".

A Carbon intensity is typically expressed as the amount of greenhouse gas emissions per unit of fuel energy in grams of Carbon dioxide equivalent per megajoule (gCO2e/MJ). Documented Carbon intensity values are available in GREET for multiple processes within a fuel supply network.

*PATHWAY DEFINITIONS WITHIN A MODELLED FUEL SUPPLY NETWORK*

Within the fuel supply network 100, a pathway comprises one or more directed routes through the nodes of a fuel supply network 100 from one or more feedstocks (e.g. crude oil, input energy) to one or more end points for a produced fuel delivered to an end-use location (e.g. a fuel station or end use point).

A pathway comprises a defined sequence of processes. In the modelled fuel supply network, the pathway is specified by a defined sequence of edges leading from a starting node (e.g. introduction of a feedstock) to an end node (e.g. distribution or use of the end fuel). Figure 3b shows an example pathway comprising four nodes (N1 to N4) connected by three directed edges (E1 to E3).

A directed pathway in the fuel supply network 100 has an associated Carbon intensity which is, typically, the sum of the Carbon intensities of the processes forming part of the pathway.

In the present disclosure, the term "reportable pathway" is used to refer to any pathway for which pathway Carbon intensity quantities are designated. This may correlate with specific pathways and certain government bodies may utilise the value of reportable pathways. For example, in the state of California, a reportable pathway would be one that requires an initial certification and subsequent periodic verification. Thus, a reportable pathway with a designated Carbon intensity quantity would aim to maintain throughputs within the component processes forming the reportable pathway at values which would maintain the Carbon intensity of the pathway within designated Carbon intensity values.

Within a modelled fuel supply network, as noted above nodes connect edges within the directed acyclic graph defining the fuel supply network. Each edge is associated with exactly two nodes: a start node and an end node. Whilst edges are more pertinent to the consideration of a fuel supply network and any associated emissions from the processes defined by those edge, nevertheless nodes serve key functions within the modelling and controlling of a fuel supply network.

Figures 3c to 3f define specific examples of unique node forms. First, a node with one or more outgoing edges only (i.e. a node with no incoming edges) represents the introduction of a feedstock into a pathway. Such nodes are designated as "source nodes" and an example is shown in Figure 3c.

Secondly, a node having one or more incoming edges only (i.e. a node having no outgoing edges) represents a final end state of a fuel along a pathway (e.g. a final end state may comprise fuel sold at a fuel station or after consumption of the fuel in a vehicle). Nodes of this type are defined as "sink nodes" and an example is shown in Figure 3d.

Thirdly, a node comprising a greater number of incoming edges than outgoing edges references a mixing process. More particularly, a node having a plurality of incoming edges and a single outgoing edge represents the mixing of materials into a single combined stream. These nodes are defined as "mixing nodes" and an example is shown in Figure 3e.

Finally, a node with a greater number of outgoing edges than incoming edges (e.g. the opposite of a mixing node) is known as a "splitter node". More particularly, a splitter node comprises one or more incoming edges and two or more outgoing edges represents the potential to split a material stream among several downstream processes. An example of such a splitter node is shown in Figure 3f.

In embodiments, a fuel supply network comprises multiple processes, represented in the graphical modelling as edges, and multiple nodes which connect the edges. In embodiments, a fuel supply network comprises a multiplicity of pathways, each of which is a defined sequence of processes leading from a source node to a sink node. In embodiments, a fuel supply network may have hundreds or even thousands of pathways.

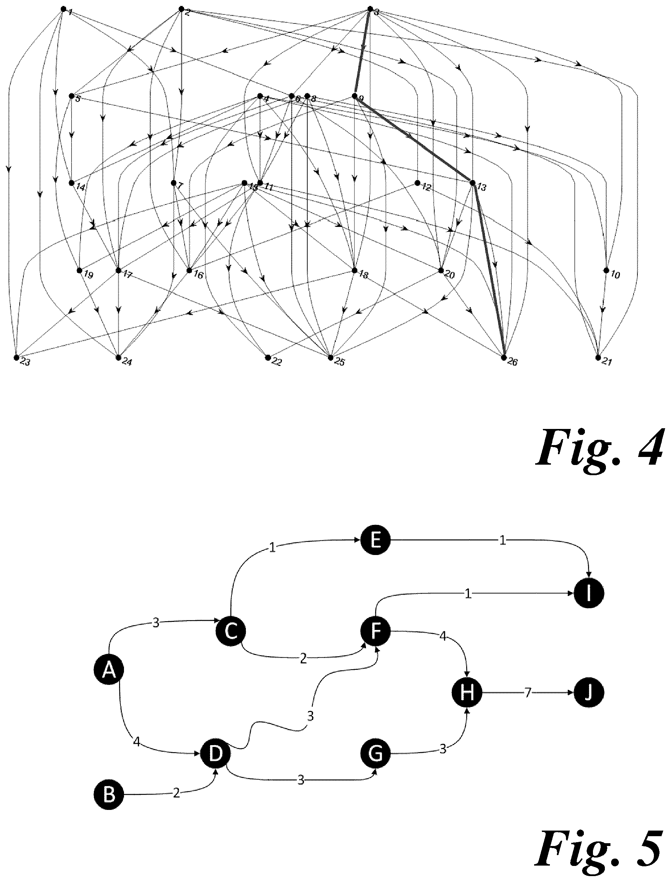

A non-limiting example of a fuel supply network represented as a directed acyclic graph 100 is shown in Figure 4. In embodiments, this directed acyclic graph comprises in total six source nodes (nodes 1, 2, 3, 4, 8 and 15) and six sink nodes (nodes 21, 22, 23, 24, 25 and 26).

The directed acyclic graph has a total of 26 nodes and 76 edges, which define a total of 128 different pathways. A non-limiting exemplary pathway is shown in a bold line and comprises the series of edges leading from node 3 to node 9, node 9 to node 13, and node 13 to node 26.

The above examples illustrate the graphical modelling of fuel supply networks which, in embodiments, form aspects of the present invention.

*DESIGNATED PATHWAY QUANTITIES*

Designated pathway quantities can materially affect the operation of a fuel supply network. For example, in California, each certified fuel pathway is required to undergo an annual verification review by an independent third party, unless there is no reported quantity for the pathway during the year.

As a result, in order to reduce pathway verification costs, it may be advantageous for the operator of the fuel supply network to minimize the number of pathways with reported quantities.

Further, it is desirable to ensure that Carbon intensities of reported pathways comply with certified values. In California, the operator of a fuel supply network may be deemed out of compliance and be subjected to financial penalties if a verification review determines that the actual Carbon intensity of a reportable pathway with non-zero quantities exceeded the certified Carbon intensity.

The present disclosure provides, in embodiments, a control system operable to regulate process flows/throughput and designate pathway quantities to forestall many instances where actual Carbon intensities of a reportable pathway exceed certified values.

*EXPRESSING A FUEL SUPPLY NETWORK AS A SYSTEM OF LINEAR EQUATIONS*

Given specified throughputs for each process in a fuel supply network, the reportable quantities for each defined pathway may not be uniquely determined.

In embodiments, the present invention defines a relationship between process throughputs/flows and reportable pathway quantities, and implements the determined relationship as a constraint in a pathway-determining control system.

Let $r$ be a vector of designated pathway quantities. Let $e$ be a vector of average edge (process) throughput for a predefined time period. On the assumption that e and r utilise the same measurement units, then the vector of designated pathway quantities must satisfy the relationship of equation (1):

$$(1) \qquad Pr = e$$

where P is a matrix having a number of columns equal to the number of reportable pathways and a number of rows equal to the number of edges in the network.

An element of P in row $i$ and column $j$ is equal to 1 if and only if edge $i$ is part of reported pathway $j$, and all other elements of matrix P are equal to zero. This criterion holds because, given a particular edge, mass balances dictate that the sum of the reported pathway quantities over all pathways which include the edge must equal the average flow for the edge.

*CONSTRAINTS ON REPORTABLE PATHWAY DEFINITIONS*

Equation (1) between reportable pathway quantities and average edge throughputs has numerous implications. Equation (1) specifies a linear system of equations, with the vector e being known and the vector $r$ being an unknown which must satisfy equation (1).

It is well known that a linear system of equations such as equation (1) may have either a) no solution, b) exactly one solution, or c) infinitely many solutions, depending on certain conditions.

The case where there is no solution to equation (1) may arise when there are errors in measuring or reporting average edge throughputs. There are various known methods for reconciling data and removing outliers to ensure that the data in a flow network are self-consistent. However, for the purposes of the present disclosure it is assumed henceforth that the system defined by equation (1) has either one solution or infinitely many solutions.

The case where the system of linear equations defined by equation (1) has exactly one solution implies that the reportable pathway quantities are uniquely determined by the average edge throughputs. The system defined by equation (1) has exactly one solution if and only if the rank of the matrix P is equal to the number of reportable pathways, which is the dimension of the vector $r$. As is known, the rank of a matrix is the dimension of the vector space spanned by its columns. In practice this corresponds to the number of linearly independent columns of the matrix.

The case where the system of linear equations defined by equation (1) has infinitely many solutions provides flexibility in the selection of designating reportable pathway flows given average edge throughputs. The system defined by equation (1) has infinitely many solutions if and only if the rank of the matrix P is less than the number of reportable pathways, which is the dimension of the vector $r$ (dim ($r$)). This provides a constraint on the number of reportable pathways which may be used to achieve optimised results.

As will be shown below, the condition rank (P) < dim ($r$) may hold for a large integrated fuel supply network, depending on the choice of reportable pathways. When this condition holds and average edge throughputs are self-consistent, then there will be infinitely many solutions for reportable pathway quantities.

The practical implication of this is that, given average process throughputs, a pathway-designating control system for a fuel supply network has considerable flexibility in determining how to designate pathway quantities if the rank of the matrix has a value less than the number of reportable pathways. This latitude in designating pathway quantities is beneficial for the operator of a fuel supply network in determining an optimal pathway distribution, and is counterintuitive in that an initially potentially larger number of designated reportable pathways may lead to more optimal results.

*PATHWAY DESIGNATING EXAMPLES*

In embodiments, Figure 5 shows a model of a simple fuel supply network to illustrate the flexibility in designating pathway quantities that is obtained when rank(P) < dim (*r*). The fuel supply network has ten nodes (*A, B, C, D, E, F, G, H, I,* and *J*) and twelve edges ($A \rightarrow C, A \rightarrow D, B \rightarrow D, C \rightarrow E, C \rightarrow F, D \rightarrow F, D \rightarrow G, E \rightarrow I, F \rightarrow H, F \rightarrow I, G \rightarrow H$, and $H \rightarrow J$).

As a result, the fuel supply network has nine pathways (*ACEI, ACFI, ACFHJ, ADFI, ADFHJ, ADGHJ, BDFI, BDFHJ,* and *BDGHJ*). For the fuel supply network shown in Figure 5, if all pathways are selected as reportable pathways, then equation (1) takes the form of equation (2):

$$(2) \quad \begin{bmatrix} 1 & 1 & 1 & 0 & 0 & 0 & 0 & 0 & 0 \\ 0 & 0 & 0 & 1 & 1 & 1 & 0 & 0 & 0 \\ 0 & 0 & 0 & 0 & 0 & 0 & 1 & 1 & 1 \\ 1 & 0 & 0 & 0 & 0 & 0 & 0 & 0 & 0 \\ 0 & 1 & 1 & 0 & 0 & 0 & 0 & 0 & 0 \\ 0 & 0 & 0 & 1 & 1 & 0 & 0 & 0 & 0 \\ 0 & 0 & 0 & 0 & 0 & 1 & 0 & 0 & 1 \\ 1 & 0 & 0 & 0 & 0 & 0 & 0 & 0 & 0 \\ 0 & 0 & 1 & 0 & 1 & 0 & 0 & 1 & 0 \\ 0 & 1 & 0 & 1 & 0 & 0 & 1 & 0 & 0 \\ 0 & 0 & 0 & 0 & 0 & 1 & 0 & 0 & 1 \\ 0 & 0 & 1 & 0 & 1 & 1 & 0 & 1 & 1 \end{bmatrix} \begin{bmatrix} ACEI \\ ACFI \\ ACFHJ \\ ADFI \\ ADFHJ \\ ADGHJ \\ BDFI \\ BDFHJ \\ BDGHJ \end{bmatrix} = \begin{bmatrix} A \rightarrow C \\ A \rightarrow D \\ B \rightarrow D \\ C \rightarrow E \\ C \rightarrow F \\ D \rightarrow F \\ D \rightarrow G \\ E \rightarrow I \\ F \rightarrow H \\ F \rightarrow I \\ G \rightarrow H \\ H \rightarrow J \end{bmatrix}$$

The matrix of zeros and ones in equation (2) is the pathway matrix P. Pathway matrix P has a number of columns equal to the number of reportable pathways (which in this example is equal to the number of pathways) and a number of rows equal to the number of edges in the network.

The rank of the matrix P in equation (2) may be determined utilising linear algebra. A known linear algebra software package such as MATLAB may be used.

The rank of P in equation (2) is 7. Given that rank(P) = 7 < dim(r) = 9, the system of equations (2) has infinitely many solutions for the pathway quantity vector *r* given the average edge throughput vector *e.*

The edges in the fuel supply network illustrated in Figure 5 are labelled with average edge throughputs over a predetermined time period. For example, the average edge throughput for the edge $A \rightarrow C$ is equal to 3, while the average edge throughput for the edge $F \rightarrow H$ is equal to 4. Given the average edge throughputs illustrated in Figure 5, in embodiments, the system of equations (2) may be used to designate pathway quantities.

In other words, equation (2) can be utilised to define the fuel supply network of Figure 5 as a set of linear equations. These linear equations can then be solved to determine one or more sets of pathway quantity designations.

An example of this is shown in Table 1 below. Two potential pathway quantities designations for the fuel supply network and the edge throughputs of Figure 5 are shown in Table 1. Both designations satisfy the system of linear equations as defined by equation (2). One potential designation indicates zero quantities for pathways *ACFHJ, BDFI,* and *BDFHJ.* The alternative quantity designation indicates zero quantities for pathways *ACFI, ACFHJ,* and *BDGHJ.*

**Table 1**

| Pathway | One potential quantity designation | An alternative quantity designation |
|---------|:---:|:---:|
| *ACEI* | 1 | 1 |
| *ACFI* | 1 | 0 |
| *ACFHJ* | 0 | 0 |
| *ADFI* | 1 | 2 |

(continued)

| Pathway | One potential quantity designation | An alternative quantity designation |
|---|---|---|
| *ADFHJ* | 3 | 1 |
| *ADGHJ* | 1 | 3 |
| *BDFI* | 0 | 1 |
| *BDFHJ* | 0 | 1 |
| *BDGHJ* | 2 | 0 |

*OPTIMISATION OF SELECTION OF REPORTABLE PATHWAYS*

Whilst the above example illustrates flexibility when designating a larger number of reportable pathways, practically speaking it may be preferable to designate fewer reportable pathways. There are two primary reasons that operators of a fuel supply network typically select a relatively small subset of the total number of pathways in a fuel supply network for certification and reporting.

First, in large integrated fuel supply networks the total number of pathways may be very large and consideration of all pathways may be an intractable problem. Secondly, commercial, practical and financial considerations associated with the certification and verification of reportable pathways render it less desirable to certify large numbers of pathways.

In embodiments, the present disclosure identifies, for the first time, that the performance of a pathway-designating control system for a fuel supply network is affected by the selection of the set of reportable pathways for the network and too restrictive a selection of reportable pathways may limit the opportunity for optimization.

As a simple illustration, consider again the fuel supply network shown in Figure 5. If the pathways *ACFI* and *ADFHJ* were omitted from the set of reportable pathways such that the set of reportable pathways were (*ACEI, ACFHJ, ADFI, ADGHJ, BDFI, BDFHJ,* and *BDGHJ*), then the pathway matrix would be:

$$P' = \begin{bmatrix} 1 & 1 & 0 & 0 & 0 & 0 & 0 \\ 0 & 0 & 1 & 1 & 0 & 0 & 0 \\ 0 & 0 & 0 & 0 & 1 & 1 & 1 \\ 1 & 0 & 0 & 0 & 0 & 0 & 0 \\ 0 & 1 & 0 & 0 & 0 & 0 & 0 \\ 0 & 0 & 1 & 0 & 0 & 0 & 0 \\ 0 & 0 & 0 & 1 & 0 & 0 & 1 \\ 1 & 0 & 0 & 0 & 0 & 0 & 0 \\ 0 & 1 & 0 & 0 & 0 & 1 & 0 \\ 0 & 0 & 1 & 0 & 1 & 0 & 0 \\ 0 & 0 & 0 & 1 & 0 & 0 & 1 \\ 0 & 1 & 0 & 1 & 0 & 1 & 1 \end{bmatrix}$$

In this example, pathway matrix P has a number of columns equal to the number of reportable pathways (which in this example is 7 and is fewer than the total the number of pathways) and a number of rows equal to the number of edges in the network.

The rank of the pathway matrix P' is 7, which is equal to the number of reportable pathways. Thus rank(P') = 7 = dim($r$) and the control system would have no flexibility in designating pathway quantities.

However, this can be changed by the addition of just a single extra reportable pathway *ACFI*. This would then mean that rank(P) = 7 < dim($r$) = 8, and so infinitely many solutions would be available to the control system. This would ensure that the control system would have flexibility in designating pathway quantities to achieve a maximised or optimal result.

In embodiments, the invention comprises reportable pathways which are selected such that rank(P) < dim ($r$).

*CARBON INTENSITY FACTORS*

As noted above, it is desirable for an operator of a fuel supply network to ensure that pathways with reported quantities have Carbon intensities which conform with the certified values. In non-limiting embodiments of the present invention, at least three of processes within a fuel supply network have associated controllers and sensors to enable monitoring of the actual Carbon intensity of the respective process.

Further, in embodiments, the control system of the present invention utilises monitored Carbon intensities to designate pathway quantities. In a non-limiting example, consider a fuel supply network in which Process A, Process B, and Process C are equipped with sensors which permit ongoing monitoring of the actual Carbon intensity of the process.

Process A and Process C are both part of Pathway J. Process B and Process C are part of Pathway K. In a situation where both Process A and Process C exceed certified Carbon intensities such that Pathway J exceeds its certified Carbon intensity, but neither Process B nor Pathway K exceed certified Carbon intensities, the pathway-determining control system may preferentially designate fuel quantities to Pathway K over Pathway J to the extent permitted by equation (1). This may limit or potentially eliminate the reportable quantity of fuel associated with Pathway J.

Consider again the potential pathway designations in Table 1 for the fuel supply network of Figure 5. Suppose that the processes B->D, D->F, and D->G have monitored Carbon intensities. Consider now the scenario where both process B->D and D->F have monitored Carbon intensities which exceed certified values but the monitored Carbon intensity for D->G complies with certified values.

In such a scenario, in embodiments, the pathway-designating control system is operable to select the alternative quantity designation to ensure that all pathways with non-zero designated quantities comply with certified pathway Carbon intensities.

*EDGE-ASSOCIATED REPORTABLE PATHWAY OPTIMISATION*

In embodiments, the present invention is operable to enhance the performance of a pathway-designating control system through utilisation of the number and layout of reportable pathways associated with each edge. In embodiments, each edge is a member of a number of reportable pathways for which a lower bound is the minimum of the number of pathways in the set of all pathways which include the edge and a certain integer N.

In embodiments, N may take values of 2, 3, or 4. To the extent permitted by the layout of the directed acyclic graph which represents the fuel supply network, it is beneficial for every edge to be associated with at least two reportable pathways. If an edge is associated with only a single reportable pathway, then the designated quantity for the pathway for a period of time is necessarily equal to the average throughput for the edge over the period of time.

In contrast, if the number of pathways is greater than the number of edges in the network, and if an edge is associated with at least two pathways, then the pathway-designating control system will often have latitude in associating throughput for an edge among the two or more pathways.

In embodiments, a set of reportable pathways which minimize a sum of a pairwise pathway similarity metric over all pairs of pathways in the reportable subset can be incorporated.

In some embodiments, the pairwise pathway similarity metric is a function of the number of edges that are common to a pair of pathways. For example, an embodiment may define the pairwise pathway similarity metric as the number of edges that are common to a pair of pathways.

Numerical simulations on simulated fuel supply networks demonstrate that when N equals 2, 3, or 4 there is substantial benefit in enhancing the extent to which pathways with reported quantities comply with certified Carbon intensities. However, where N is greater than 4 there is limited or no incremental benefit in reliably satisfying Carbon intensities of designated pathways.

*EXAMPLES*

The benefits of approach of embodiments of the present invention were confirmed via numerical simulation. For each choice of N, 100 directed acyclic graphs were randomly generated. The randomly generated directed acyclic graphs had up to 10 edges (processes) per pathway, between 2 and 10 source nodes, between 2 and 10 sink nodes, and between 6 and 2400 total pathways.

The certified value of the Carbon intensity of each process was assumed to be 1 $gCO_2e/MJ$. The actual value of the Carbon intensity of each process for a certain period of time was a randomly generated number selected from Gaussian distribution with mean 0.95 $gCO_2e/MJ$ and a variance of 0.01 $gCO_2e/MJ$.

In embodiments, for each simulated directed acyclic graph, a selection of reportable pathways (the "optimal set of reportable pathways") comprising a subset of all pathways was determined to ensure that each edge was a member of a number of reportable pathways for which a lower bound was the minimum of the number of pathways in the set of all pathways which include the edge and a certain integer N.

Furthermore, the selected subset of reportable pathways, among all potential subsets of reportable pathways satisfying the lower bound, was the subset which minimized the sum, over all pairs of reportable pathways, of a certain pairwise pathway similarity metric.

Given two pathways, the pairwise pathway similarity metric was defined as the number of shared edges by the two pathways. The selection of the set of reportable pathways was implemented as a mixed integer linear program (MILP) optimization in Gurobi, a well-known optimization software package.

For the purposes of comparison and evaluation, a minimal set of reportable pathways (the "minimal set of reportable pathways"), such that each edge was associated with at least one reportable pathway, was also determined by solving an MILP in Gurobi.

For the purposes of comparison and evaluation, another set of reportable pathways (the "suboptimal set of reportable pathways"), was found such that each edge was a member of a number of reportable pathways for which a lower bound was the minimum of the number of pathways in the set of all pathways which include the edge and the certain integer N. The suboptimal set of reportable pathways had a number of pathways equal to the optimal set of reportable pathways; however, the suboptimal set of reportable pathways did not minimize a pairwise pathway similarity metric.

For a specific randomly generated directed acyclic graph, the optimal set of reportable pathways, the minimal set of reportable pathways, and the suboptimal set of reportable pathways was determined.

Then, in embodiments of the pathway-designating control system, pathway quantities were designated in order to minimize the number of reportable pathways with non-zero designated quantities which exceeded the certified pathway Carbon intensity value.

This designation was made separately with A) the optimal set of reportable pathways, B) the minimal set of reportable pathways, and C) the suboptimal set of reportable pathways.

To illustrate the numerical simulation process, consider one specific directed acyclic graph which was generated for numerical simulation. The graph has 6 source nodes, 6 sink nodes, 28 total nodes, 102 edges, and a total of 222 pathways. With N=2, the optimal set of reportable pathways comprised 99 pathways, the minimal set of reportable pathways comprised 61 pathways, and the suboptimal set of reportable pathways comprised 99 pathways.

Using the optimal set of reportable pathways, there were a total of 11 pathways with non-zero designated quantities (out of a total of 99 reportable pathways) which did not comply with certified pathway Carbon intensities.

Using the minimal set of reportable pathways, there were a total of 14 pathways with non-zero designated quantities (out of a total of 61 reportable pathways) which did not comply with certified pathway Carbon intensities.

Finally, using the suboptimal set of reportable pathways, there were a total of 13 pathways with non-zero designated quantities (out of a total of 99 reportable pathways) which did not comply with certified pathway Carbon intensities.

For this instance, the optimal set of reportable pathways had the fewest number of pathways with non-zero designated quantities which did not comply with certified pathway Carbon intensities.

Table 2 below summarizes key aspects of the numerical simulation results. It shows that an optimal set of reportable pathways selected based on minimizing a pairwise pathway similarity metric with N=2, 3, or 4 can reduce the number of reported non-compliant pathways by about 20-30% relative to a minimal set of reportable pathways.

Furthermore, an optimal set of reportable pathways determined based on a pairwise pathway similarity metric can reduce the number of reported non-compliant pathways by about 10% relative to a suboptimal set of reportable pathways containing the same number of pathways. Finally, there is no incremental benefit achieved by setting N>4.

**Table 2**

| N | Average pathways with non-zero reportable quantities which were noncompliant using the optimal set of reportable pathways, as a percentage of pathways with non-zero reportable quantities which were noncompliant using a minimal set of reportable pathways | Average pathways with non-zero reportable quantities which were noncompliant using the optimal set of reportable pathways, as a percentage of pathways with non-zero reportable quantities which were noncompliant using a suboptimal set of reportable pathways | Average number of pathways in the optimal set of reportable pathways, as a percentage of the total number of pathways |
|---|---|---|---|
| 1 | 101.3% | 102.7% | 45.1% |
| 2 | 79.3% | 89.6% | 63.7% |
| 3 | 74.1% | 82.0% | 72.5% |
| 4 | 70.2% | 90.3% | 75.6% |
| 5 | 73.6% | 92.7% | 83.5% |

*TIMESCALE DEFINITIONS*

Timescale issues inherent in controlling throughputs/flows while simultaneously designating pathway quantities may arise. In embodiments, the present invention addresses these issues.

Processes in a fuel supply network typically benefit from receiving control element setpoints at least daily. Many processes in a fuel supply network receive control element setpoints hourly or more frequently.

In contrast, designations of pathway quantities are often over much longer timescales, e.g. on a quarterly basis. In embodiments, the present invention is operable to address the timescale discrepancy between computing throughput setpoints for processes and designating pathway quantities.

As noted previously, the vector of designated pathway quantities r for a period of time and the vector e of average edge (process) throughputs for the period of time must satisfy the relationship of equation (1) *Pr = e* where P is a matrix where an element in row $i$ and column $j$ is equal to one if and only if edge $i$ is part of reported pathway $j$, and all other elements of matrix P are equal to zero.

If the period for designating pathway quantities is one quarter of a year, then the vector e of should contain average edge throughputs for the period of one quarter of a year. In embodiments, the control system computes the vector as equation (3) below:

$$(3) \qquad e = \begin{bmatrix} \alpha h_1 + \beta c_1 \\ \vdots \\ \alpha h_n + \beta c_n \end{bmatrix}$$

where $h_1$ is the quarter-to-date historical average edge throughput for edge 1, $h_n$ is the quarter-to-date historical average edge throughput for edge $n$, $c_1$ is the the current setpoint for throughput for edge 1, $c_n$ is the current setpoint for throughput for edge $n$, and $\alpha$ and $\beta$ are numbers in the range (0,1) such that $\alpha + \beta = 1$ and $\alpha$ corresponds to the fraction of the quarter of a year that has already elapsed.

It is apparent that the vector equation (3) converges to the historical average edge throughput for the quarter as the end of the quarter approaches, while also capturing the effects of the current controller throughput setpoints on the designated pathway quantities.

In embodiments, determination of edge throughput setpoints in order to achieve determined designated pathway quantities is carried out. In such embodiments, the control system considers future edge throughput setpoints in time periods known as *epochs.*

An epoch is defined by a start time (for example, 25 August 2021 at 9 AM) and a duration (for example, 8 hours). Embodiments may define the epochs such that none of the epochs overlap and the union of the epochs fully covers the future planning period.

In embodiments, edge throughput setpoints can be determined in order to control the control elements of the processes represented by the respective edges in order to achieve a desired result. In this case, the average edge throughputs are calculated as equation (4):

$$(4) \qquad e = \begin{bmatrix} \alpha h_1 + \beta_1 c_{1,1} + \beta_2 c_{1,2} + \cdots + \beta_{m-1} c_{1,m-1} + \beta_m c_{1,m} \\ \vdots \\ \alpha h_n + \beta_1 c_{n,1} + \beta_2 c_{n,2} + \cdots + \beta_{m-1} c_{n,m-1} + \beta_m c_{n,m} \end{bmatrix}$$

where $h_1$ is the quarter-to-date historical average edge throughput for edge 1, $h_n$ is the quarter-to-date historical average edge throughput for edge $n$, $c_{1,1}$ is the throughput setpoint for edge 1 in epoch 1, $c_{1,2}$ is the throughput setpoint for edge 2 in epoch 2, $c_{1,m-1}$ is the throughput setpoint for edge 1 in epoch $m$ - 1, $c_{1,m}$ is the throughput setpoint for edge 1 in epoch m, $c_{n,1}$ is the throughput setpoint for edge $n$ in epoch 1, $c_{n,2}$ is the throughput setpoint for edge $n$ in epoch 2, $c_{n,m-1}$ is the throughput setpoint for edge $n$ in epoch m - 1, and $c_{n,m}$ is the throughput setpoint for edge $n$ in epoch m.

Furthermore, the weighting coefficients $\alpha, \beta_1, \beta_2, \cdots, \beta_{m-1}, \beta_m$ are defined such that $\alpha + \beta_1 + \beta_2 + \cdots + \beta_{m-1} + \beta_m = 1$ and the magnitude of the coefficient is proportional to the duration of the epoch.

In embodiments which accommodate planning for future edge throughput setpoints, a throughput setpoint $c_{n,m}$ for edge $n$ in epoch m is constrained to be zero if operational plans dictate that the stationary or transportation process represented by edge $n$ will not be in service during epoch m.

For example, if edge $n$ represents the transportation of renewable diesel via a particular railway, and the railway is scheduled to be out of service during epoch m, then $c_{n,m} = 0$ in equation (4). As another example, if edge $n$ represents a processing unit operation for a fuel or intermediate, and the unit operation is scheduled to be out of service during epoch m, then $c_{n,m} = 0$.

*METHOD*

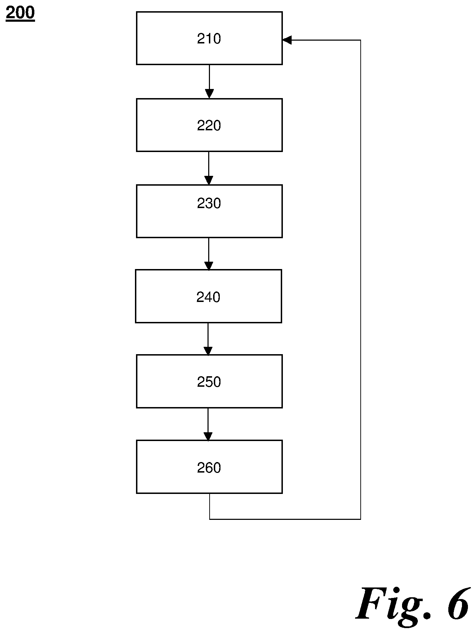

Figure 6 shows a method 200 according to an embodiment. In embodiments, there is provided a method of controlling a fuel supply network comprising one or more feedstock sources, one or more processes and one or more end-use points. The method is executed by at least one hardware processor.

At step 210, a directed acyclic graph representative of the fuel supply network is defined using a hardware processor. The directed acyclic graph comprises a set of fuel pathways, each fuel pathway extending between one or more source nodes each representative of a feedstock source of the fuel supply network to one or more sink nodes each representative of an end-use point of the fuel supply network.

Each pathway comprises one or more edges representative of one or more processes of the fuel supply network. One or more edges are associated with a throughput determined by one or more control elements of the fuel supply network operable to control the process of the fuel supply network associated with the respective edge.

At step 220, a set of reportable fuel pathways is determined. The set of reportable fuel pathways is a subset of the set of fuel pathways. The determination may, in embodiments, be done as set out above where, to the extent permitted by the layout of the directed acyclic graph which represents the fuel supply network, each edge is associated with at least two reportable pathways. In embodiments, the number N of reportable pathways associated with each edge may take values of 2, 3, or 4.

The number of reportable pathways may also constrained by the requirement that rank(P) < dim (r) as a constraint on equation (1) in order to provide flexibility in the selection of preferred pathways.

The selection of the set of reportable pathways at step 220 is implemented on a hardware controller and may be determined from a solution of linear equations. Step 220 may, in embodiments, be implemented as a mixed integer linear program (MILP) optimization in software.

Step 220 may, in embodiments, be optional. For example, for the control of a fuel supply network, step 220 may be performed as part of an initialization process to determine a set of reportable pathways. Subsequent iterations or running of the fuel supply network may utilize the set of determined reportable pathways determined in the initialization process and so step 220 may not need to be performed again for this process.

Additionally or alternatively, step 220 may be performed routinely or on demand as required. In addition, specific triggers may prompt step 220 to be run. For example, if a process within a fuel supply network is changed, or new processes, nodes and/or pathways are added or removed from the fuel supply network.

At step 230, average pathway throughputs for one or more of the determined reportable pathways for a predefined time period are determined. The predetermined time period may be set based on any suitable criteria. For example, the predetermined time period may be set as a quarter of a year. Step 230 may be carried out at any time point t within the predetermined time period.

If time point t is at the start of the predetermined time period, data relating to the current and future throughput setpoint values for one or more control elements of the fuel supply network processes and represented by respective edges may be utilized.

If the time point t is during the predetermined time period, the average pathway throughputs are determined based on historical average pathway throughputs since the start of the predetermined time period and on current and future throughput setpoint values for one or more control elements of the fuel supply network processes and represented by respective edges.

If the time point t is at the end of the predetermined time period, the average pathway throughputs are determined based on historical average pathway throughputs for the relevant edges.

At step 240, pathway quantities for one or more reportable fuel pathways are determined and designated. This is done based on equation (1) and solving the resultant linear equations to determine solutions for the designated pathway quantities. In embodiments, steps 230 and 240 may be carried out simultaneously as part of a single solver process.

In other words, a set of reportable fuel pathways are defined as a system of linear equations, the set of reportable fuel pathways comprising a subset of the set of fuel pathways. Designated pathway quantities are then calculated for the set of reportable fuel pathways such that the designated pathway quantities satisfy the system of linear equations.

More particularly, in step 240, the vector of average pathway quantities e (from equation (1)) is determined from *inter alia* the average pathway throughput for each fuel pathway at step 230, and the number of reportable fuel pathways determined in step 220. Then, the reportable fuel pathways of the fuel supply network can be expressed as a set of linear equations as per equation (1). These linear equations are then solved in step 240 to determine solutions for preferred and/or maximized and/or optimal reportable pathway quantities for the determined reportable pathways.

In embodiments, pathway quantities may be designated in order to minimize the number of reportable pathways with non-zero designated pathway quantities which exceeded the certified pathway Carbon intensity value for that pathway. This may be implemented as a further constraint on the results of step 240 in order to select a solution to equation (1) which minimizes the number of reportable pathways having non-zero designated pathway quantities.

At step 250, one or more throughput setpoint values are determined for one or more edges in the directed acyclic graph based on the designated pathway quantities for one or more reportable fuel pathways associated with said one or more edges. In other words, control setpoints for the operational processes associated with the respective edges of the reportable pathways are determined in order to achieve the designated pathway quantities as determined in step 240.

At step 260, one or more controllers are utilized to control one or more control elements of the processes associated with the one or more edges based on the determined throughput setpoint values for the respective one or more edges. This may, in non-limiting embodiments, involve control of processes in the respective reportable fuel pathways in order by controlling throughput in these processes to achieve the desired designated pathway quantities.

By providing such a method, a fuel supply network can be controlled in an improved manner. More particularly, preferred reportable pathways can be identified and the number of said reportable pathways minimised in order to improve the efficiency and Carbon Intensity compliance of the fuel supply network.

The process may be repeated for a further predetermined time period or as required. As noted above, step 220 may be optional if the process is repeated in specific circumstances.

While the invention has been described with reference to the preferred embodiments depicted in the figures, it will be appreciated that various modifications are possible within the spirit or scope of the invention as defined in the following claims.

In this specification, unless expressly otherwise indicated, the word "or" is used in the sense of an operator that returns a true value when either or both of the stated conditions are met, as opposed to the operator "exclusive or" which requires only that one of the conditions is met. The word "comprising" is used in the sense of "including" rather than to mean "consisting of".

Where applicable, various embodiments provided by the present disclosure may be implemented using hardware, software, or combinations of hardware and software. Also, where applicable, the various hardware components and/or software components set forth herein may be combined into composite components comprising software, hardware, and/or both without departing from the spirit of the present disclosure. Where applicable, the various hardware components and/or software components set forth herein may be separated into sub-components comprising software, hardware, or both without departing from the scope of the present disclosure. In addition, where applicable, it is contemplated that software components may be implemented as hardware components and vice-versa.

Software, in accordance with the present disclosure, such as program code and/or data, may be stored on one or more computer readable mediums. It is also contemplated that software identified herein may be implemented using one or more general purpose or specific purpose computers and/or computer systems, networked and/or otherwise. Where applicable, the ordering of various steps described herein may be changed, combined into composite steps, and/or separated into sub-steps to provide features described herein.

While various operations have been described herein in terms of "modules", "units" or "components," these terms should not limited to single units or functions. In addition, functionality attributed to some of the modules or components described herein may be combined and attributed to fewer modules or components.

It will be apparent to those of ordinary skill in the art that changes, additions or deletions may be made to the disclosed embodiments without departing from the spirit and scope of the invention. For example, one or more portions of methods described above may be performed in a different order (or concurrently) and still achieve desirable results.

**Claims**

1. A computer-implemented method of controlling a fuel supply network comprising one or more feedstock sources, one or more processes and one or more end-use points, the method comprising:

    defining, using a processor, a directed acyclic graph representative of the fuel supply network, said directed acyclic graph comprising a set of fuel pathways, each fuel pathway extending between one or more source nodes each representative of a feedstock source of the fuel supply network to one or more sink nodes each representative of an end-use point of the fuel supply network and comprising one or more edges representative of one or more processes of the fuel supply network, wherein one or more edges are associated with a throughput determined by one or more control elements of the fuel supply network operable to control the process of the fuel supply network associated with the respective edge;
    defining, using a processor, a set of reportable fuel pathways as a system of linear equations, the set of reportable fuel pathways comprising a subset of the set of fuel pathways;
    calculating, using a processor, designated pathway quantities for the set of reportable fuel pathways such that the designated pathway quantities satisfy the system of linear equations;
    determining, using a processor, one or more throughput setpoint values for one or more edges in the directed acyclic graph based on the designated pathway quantities for one or more reportable fuel pathways associated with said one or more edges;
controlling, using one or more controllers, one or more control elements of the processes associated with the one or more edges based on the determined throughput setpoint values for the respective one or more edges.

2. The computer-implemented method of claim 1, wherein the step of defining a set of reportable fuel pathways as a system of linear equations further comprises determining, using a processor, average pathway throughputs for one or more of the reportable fuel pathways for a predefined time period.

3. The computer-implemented method of claim 2, wherein the step of determining average fuel pathway throughputs comprises determining the average throughput of one or more edges forming part of the respective fuel pathway within the predetermined time period.

4. The computer-implemented method of claim 3, wherein the average throughput of one or more edges is determined by the setpoint values for said edge.

5. The computer-implemented method of claim 4, wherein the average edge throughputs are calculated based on historical throughput for the respective edge and future edge throughput setpoint values for one or more epochs, each epoch being defined by a start time and a duration and falling within the predetermined time period.

6. The computer-implemented method of any one of the preceding claims, where the step of defining a set of reportable pathways as a system of linear equations further comprises expressing a vector of the average edge throughput over the predetermined time period as equal to a vector of the average pathway throughput over the period of time multiplied by a pathway matrix, wherein the elements of the pathway matrix may only take values of zero and one, and wherein an element of the matrix is equal to one if an edge is a member of a pathway and a zero if an edge is not a member of a pathway.

7. The computer-implemented method of claim 6, where the system of linear equations comprises a vector of the average edge throughputs over the period of time is equal to a vector of the average fuel pathway throughputs over the period of time multiplied by a matrix, the matrix consisting of only zeros and positive constants, and an element of the matrix equal to a positive constant if an edge is a member of a pathway and equal to zero if an edge is not a member of a pathway and/or where the rank of the pathway matrix is less than the number of reportable fuel pathways.

8. The computer-implemented method of any one of the preceding claims, further comprising, prior to the step of defining a set of reportable pathways as a system of linear equations:
determining a set of reportable fuel pathways from said set of fuel pathways.

9. The computer-implemented method of claim 8, where determining a set of reportable fuel pathways comprises:
defining each edge as a member of a number of reportable fuel pathways for which a lower bound is the minimum of: the number of pathways in the set of all fuel pathways which include the edge and a certain integer N.

10. The computer-implemented method of claim 9, wherein N is 2, 3, or 4.

11. The computer-implemented method of claim 9, wherein the set of reportable fuel pathways is determined based on a pairwise pathway similarity metric.

12. The computer-implemented method of claim 11, where the pairwise path similarity metric is a function of the number of edges that are common to each reportable fuel pathway.

13. A system for controlling a fuel supply network comprising one or more feedstock sources, one or more processes and one or more end-use points, the system comprising:
at least one hardware processor operable to perform the steps of the method of any one of claims 1 to 12.

14. The system of claim 13, further comprising a master controller, the master controller comprising one or more controllers operable to control the one or more control elements of the respective processes associated with the one or more edges.

15. The system of claim 14, wherein the master controller further comprises a sensor module operable to receive and process sensor data from one or more sensors associated with the respective processes associated with the one or more edges.

16. The computer-implemented method of any one of claims 1 to 12 or the system of any one of claims 13 to 15, wherein one or more processes are selected from the group of: fuel production, transformation, transportation, distribution, or end-use processes.

17. A computer-readable storage medium comprising program instructions which, when executed by a computer device, cause the computer device to carry out the method of any one of claims 1 to 12.

**Fig. 1**

*Fig. 2*

N₁       E₁       N₂

*Fig. 3a*

N₁   E₁   N₂   E₂   N₃   E₃   N₄

*Fig. 3b*

*Fig. 3c*

*Fig. 3e*

*Fig. 3d*

*Fig. 3f*

*Fig. 4*

*Fig. 5*

**200**

```
┌──────────────┐
│     210      │◄─────┐
└──────┬───────┘      │
       │              │
       ▼              │
┌──────────────┐      │
│     220      │      │
└──────┬───────┘      │
       │              │
       ▼              │
┌──────────────┐      │
│     230      │      │
└──────┬───────┘      │
       │              │
       ▼              │
┌──────────────┐      │
│     240      │      │
└──────┬───────┘      │
       │              │
       ▼              │
┌──────────────┐      │
│     250      │      │
└──────┬───────┘      │
       │              │
       ▼              │
┌──────────────┐      │
│     260      │      │
└──────┬───────┘      │
       └──────────────┘
```

*Fig. 6*

**EP 4 184 401 A1**

Europäisches
Patentamt

European
Patent Office

Office européen
des brevets

# EUROPEAN SEARCH REPORT

Application Number

EP 22 20 7690

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/299075 A1 (ESMAILI ALI [US] ET AL) 18 October 2018 (2018-10-18) | 1,8-17 | INV. G06Q10/0631 G06Q50/06 |
| Y | * paragraph [0002] - paragraph [0005] * <br> * paragraph [0042] - paragraph [0048] * <br> * paragraph [0052] - paragraph [0054] * <br> * paragraph [0079] - paragraph [0083] * <br> ----- | 2-7 | |
| Y | CN 109 064 033 A (CHINA NAT OFFSHORE OIL CORP; CNOOC GAS & POWER GROUP CO LTD) 21 December 2018 (2018-12-21) <br> * Summary of Invention * <br> ----- | 2-7 | |

**TECHNICAL FIELDS SEARCHED (IPC)**

G06Q

The present search report has been drawn up for all claims

| Place of search | Date of completion of the search | Examiner |
|---|---|---|
| Munich | 22 March 2023 | Hasubek, Bodo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
..................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 20 7690

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2023

| Patent document cited in search report | | Publication date | Patent family member(s) | | Publication date |
|---|---|---|---|---|---|
| US 2018299075 | A1 | 18-10-2018 | CA | 2988960 A1 | 18-10-2018 |
| | | | CN | 108732929 A | 02-11-2018 |
| | | | US | 9890908 B1 | 13-02-2018 |
| | | | US | 2018299075 A1 | 18-10-2018 |
| CN 109064033 | A | 21-12-2018 | NONE | | |

EPO FORM P0459

For more details about this annex : see Official Journal of the European Patent Office, No. 12/82